# EUROPEAN PATENT APPLICATION

(11) **EP 4 318 309 A1**
(43) Date of publication of application: **07.02.2024**
(21) Application number: 21933167.5
(22) Date of filing: 16.06.2021
(51) Int. Cl.: G06K 19/077, G06F 12/06, G11C 5/06, H01L 27/11582

(54) **MEMORY DEVICE**

(30) Priority: 23.03.2021 JP 2021048578
(71) Applicant: Kioxia Corporation, Tokyo 108-0023 (JP)
(72) Inventor: SAITO, Toshitada, Tokyo 108-0023 (JP); OTSUKA, Yasuo, Tokyo 108-0023 (JP); KONDO, Atsushi, Tokyo 108-0023 (JP)
(74) Representative: Hoffmann Eitle
(86) International application number: PCT/JP2021/022878
(87) International publication number: WO 2022/201566

(57) **Abstract**

A memory device includes a substrate 30, a non-volatile memory 14 that is provided on the substrate 30, a memory controller 13 that is provided on the substrate 30 and connected to the non-volatile memory 14, a wiring 40 that is provided on the substrate 30 and includes one end and another end, wherein the one end is connected to the memory controller 13. The memory device further includes a footprint 60 that is provided on the substrate 30 and connected to the another end of the wiring 40, an ESD protection element 12A that is provided on the substrate 30 and connected to the footprint 60, a connection terminal that is provided on the substrate 30 and electrically connectable to a host device, a via plug that is provided in the substrate, wherein one end is connected to the another end of the wiring 40, another end is connected to the connection terminal.

## Description

### Technical Field

Embodiments of the present invention relates to a memory device.

### Background Art

A memory device includes, for example, a flash memory, a memory controller, a connection terminal connectable to a host device, and an ESD (Electro Static Discharge) protection element.

### Citation List

### Patent Literature

Patent Literature 1: JP 2020-003875 A

### Summary of Invention

### Technical Problem

It is an object of the present invention to provide a memory device that can suppress the influence of ESD and suppress deterioration in the transmission characteristics of electric signals.

### Solution to Problem

A memory device of an embodiment includes a substrate, a non-volatile memory that is provided on the substrate, a memory controller that is provided on the substrate and connected to the non-volatile memory, a first wiring that is provided on the substrate and includes one end and another end, wherein the one end is connected to the memory controller. The memory device of the embodiment further includes a footprint that is provided on the substrate and connected to the another end of the first wiring, an ESD protection element that is provided on the substrate and connected to the footprint, a connection terminal that is provided on the substrate and electrically connectable to a host device, a first via plug that is provided in the substrate, wherein one end is connected to the another end of the first wiring, another end is connected to the connection terminal.

### Brief Description of Drawings

FIG. 1 is a block diagram of a memory device according to a first embodiment.
FIG. 2 is a configuration diagram of an ESD protection element.
FIG. 3 is a plan view of an outer shape of the memory device.
FIG. 4 is a side view of the outer shape of the memory device.
FIG. 5 is a plan view of the memory device according to the first embodiment.
FIG. 6 is a cross-sectional view along a line VI-VI of FIG. 5.
FIG. 7 is a cross-sectional view along a line VII-VII of FIG. 5.
FIG. 8 is a cross-sectional view along a line VIII-VIII of FIG. 5.
FIG. 9 is a plan view of a footprint of the memory device according to the first embodiment.
FIG. 10 is a plan view of a memory device according to a comparative example.
FIG. 11 is a plan view of a footprint of a memory device according to a second embodiment.
FIG. 12 is a characteristic chart illustrating transmission characteristics of electric signals of the memory device according to the embodiment and transmission characteristics of electric signals of the memory device according to the comparative example.
FIG. 13 is a plan view of a memory device according to a third embodiment.
FIG. 14 is a cross-sectional view along a line XIV-XIV of FIG. 13.
FIG. 15 is a cross-sectional view along a line XV-XV of FIG. 13.

### Description of Embodiments

Hereinafter, embodiments will be described with reference to the drawings.

### (First Embodiment)

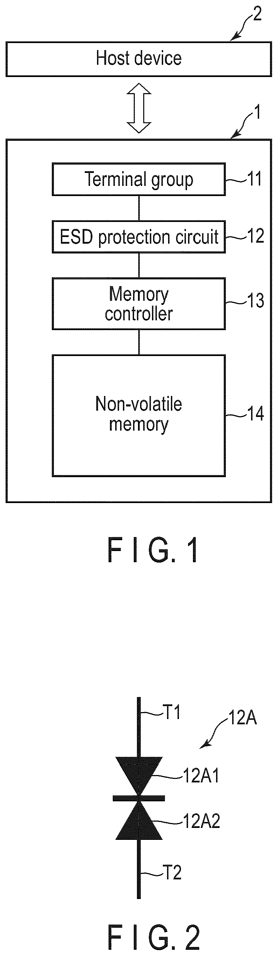

FIG. 1 is a block diagram of a memory device 1 according to a first embodiment.

The memory device 1 is a memory device such as a removable memory card electrically connectable to, for example, a host device 2. The host device 2 is, for example, an information processing device such as a personal computer or a server, a tester device, a manufacturing device, an image capturing device such as a still camera or a video camera, a mobile terminal such as a tablet computer or a smartphone, game equipment, or a car navigation system (in-vehicle terminal).

The memory device 1 includes a terminal group 11, an ESD protection circuit 12, a memory controller 13, and a non-volatile memory 14.

The terminal group 11 includes a plurality of connection terminals (not illustrated). The plurality of connection terminals are electrically connectable to the host device 2. For example, in the state in which the memory device 1 is connected to the host device 2, the plurality of connection terminals are electrically connected to the host device 2. The data transfer between the host device 2 and the memory device 1 is carried out, for example, by serial transfer.

The ESD protection circuit 12 includes a plurality of ESD protection elements (not illustrated). The plurality of ESD protection elements and the plurality of connection terminals are connected. For example, the number of the plurality of ESD protection elements and the number of the plurality of connection terminals are the same. In this case, one of the ESD protection elements is connected to one of the connection terminals, and the different ESD protection elements are connected to the different connection terminals.

FIG. 2 is a configuration diagram of an ESD protection element 12A.

The ESD protection element 12A includes a first diode 12A1, a second diode 12A2, a first terminal T1, and a second terminal T2.

The first diode 12A1 and the second diode 12A2 are connected in series. A cathode of the first diode 12A1 is connected to a cathode of the second diode 12A2. The first terminal T1 is connected to an anode of the first diode 12A1. The second terminal T2 is connected to an anode of the second diode 12A2.

When each of the diodes 12A1 and 12A2 is a Zener diode, the ESD protection element 12A is a bidirectional Zener diode.

Hereinafter, the case in which the ESD protection element 12A illustrated in FIG. 2 is used as the ESD protection element will be described, but the ESD protection element is not limited to the ESD protection element 12A. For example, the number of the diodes constituting the ESD protection element may be one. Also, the ESD protection element may further include a different kind of element that is different from the diode. The ESD protection element in use is appropriately determined depending on the type, specifications, etc. of the memory device.

The memory controller 13 illustrated in FIG. 1 controls the non-volatile memory 14. More specifically, the memory controller 13 receives commands from the host device 2 and controls the non-volatile memory 14 based on the received commands. In particular the memory controller 13 writes data instructed by the host device 2 to write to the non-volatile memory 14, reads data instructed by the host device 2 to read from the non-volatile memory 14, and transmits the data to the host device 2.

Note that the memory device 1 may include a controller other than the memory controller 13. The controller and the memory controller 13 may be configured as one controller (chip), or the controller and the memory controller 13 may be configured as different controllers (chips).

The non-volatile memory 14 is a memory which retains data in a non-volatile manner, and the non-volatile memory 14 is, for example, a NAND-type flash memory which includes a plurality of non-volatile semiconductor memory cells. The NAND-type flash memory includes, for example, a plurality of stacked NAND-type flash memory dies (not illustrated). Instead of the NAND-type flash memory, a memory including a plurality of non-volatile magnetic memory cells or phase-change memory cells may be used.

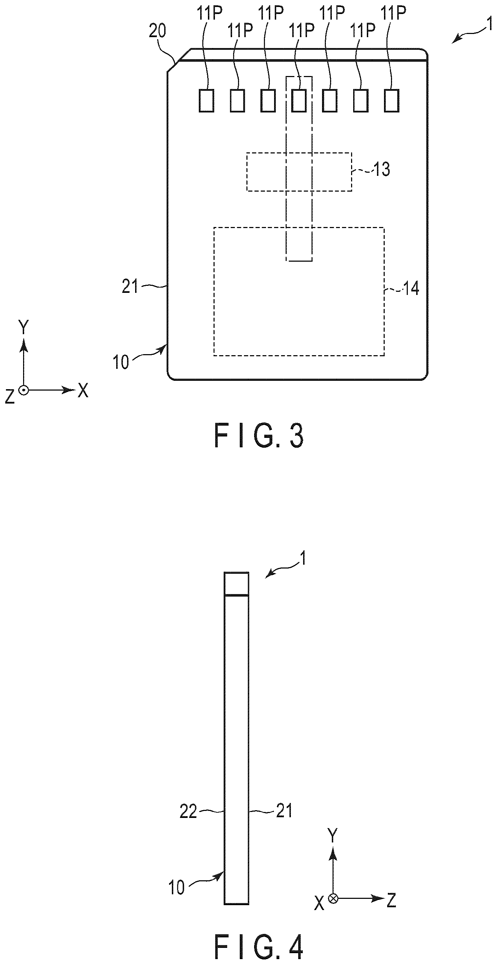

FIG. 3 is a plan view of an outer shape of the memory device 1. Note that, in FIG. 3, the memory controller 13 and the non-volatile memory 14 in the memory device 1 are illustrated by broken lines. FIG. 4 is a side view of the memory device 1.

In FIG. 3 and FIG. 4, an X-axis, a Y-axis, and a Z-axis are illustrated. The X-axis, the Y-axis, and the Z-axis are mutually orthogonal. The X-axis is along a width of the memory device 1. The Y-axis is along a length (height) of the memory device 1. The Z-axis is along a thickness of the memory device 1.

The memory device 1 is provided with a thin plate-shaped card case (also referred to as a body, housing, or package) 10. A material of the card case 10 is, for example, an insulating resin such as a polycarbonate resin or an ABS resin. The card case 10 is formed, for example, in an approximately rectangular plate shape extending in the Y-axis direction. The Y-axis direction is the longitudinal direction of the card case 10. The memory device 1 has a chamfered part 20, which shows a front or rear direction, or upward or downward direction.

As illustrated in FIG. 4, the card case 10 includes a first surface 21 and a second surface 22. The first surface 21 and the second surface 22 have approximately tetragonal (rectangular) shapes extending in the Y-axis direction. The Y-axis direction is also the longitudinal direction of the first surface 21 and the second surface 22. The first surface 21 is an approximately flat surface directed toward a positive direction of the Z-axis. The second surface 22 is positioned opposite to the first surface 21 and is an approximately flat surface directed toward a negative direction of the Z-axis.

As illustrated in FIG. 3, the memory device 1 includes a plurality of connection terminals 11P provided on the first surface 21 side. The plurality of connection terminals 11P are the previously described plurality of connection terminals of the terminal group 11 of FIG. 1. The plurality of connection terminals 11P are disposed along the X-axis. The plurality of connection terminals 11P are exposed from the card case 10. The plurality of connection terminals 11P are also referred to as external connection terminals or pads.

Note that, in FIG. 3, for simplicity, the number of the connection terminals 11P is seven, but the number of the connection terminals 11P may be larger than seven. Also, the number of the connection terminals 11P may be smaller than seven. Also, in FIG. 3, for simplicity, the plurality of connection terminals 11P are disposed in one row, but the plurality of connection terminals 11P may be disposed across a plurality of rows. The number of the connection terminals 11P disposed in each row may be the same in all rows or may be different.

Next, a device structure in the card case 10 will be described.

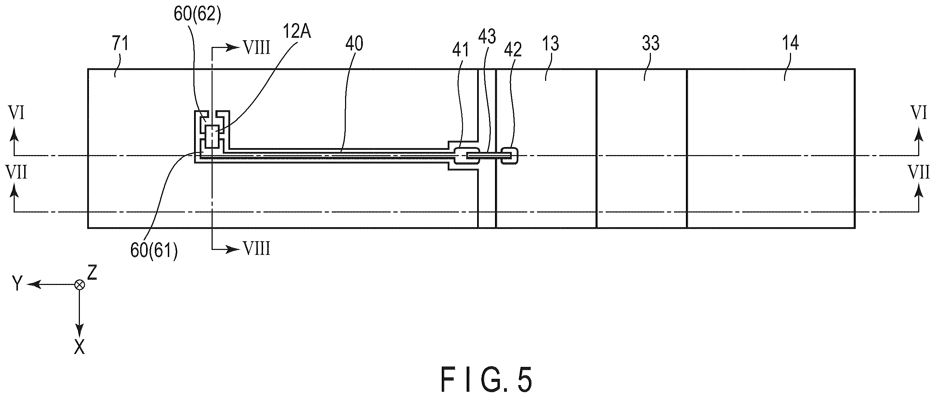

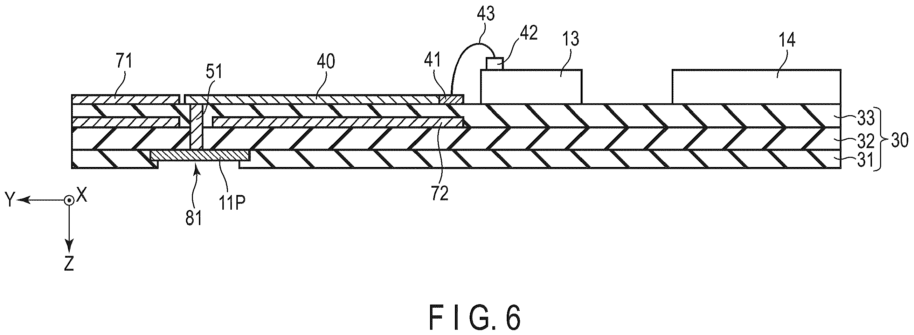

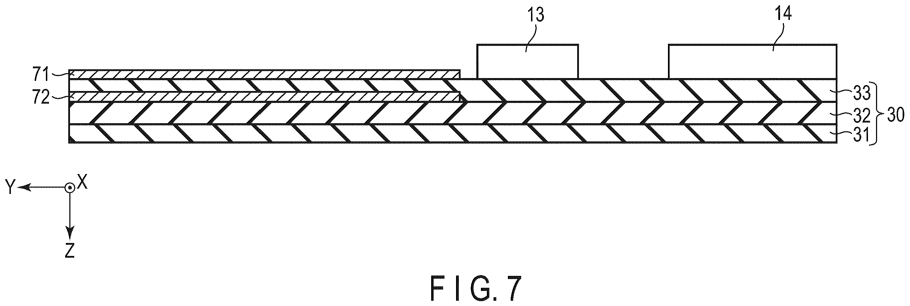

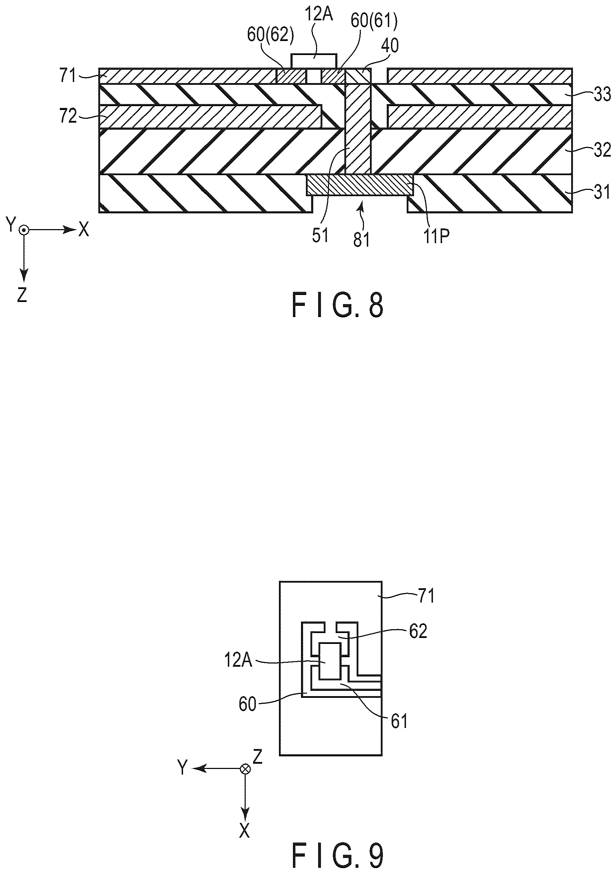

FIG. 5 is a plan view of the memory device according to the first embodiment and illustrating the area of FIG. 3 surrounded by a dashed-dotted line from the second surface 22 side. FIG. 6 is a cross-sectional view along a line VI-VI of FIG. 5. FIG. 7 is a cross-sectional view along a line VII-VII of FIG. 5. FIG. 8 is a cross-sectional view (third cross-sectional view) along a line VIII-VIII of FIG. 5. In FIG. 5 to FIG. 8, the case 10 is not illustrated. FIG. 9 is a plan view of a footprint 60.

In the case, the connection terminals 11P, the memory controller 13, the non-volatile memory 14, a substrate 30, a micro-strip line 40, a first pad electrode 41, a second pad electrode 42, a bonding wire 43, a first via plug 51, the footprint 60, a first ground plane 71, and a second ground plane 72 are provided.

The substrate 30 includes a first insulating layer 31, a second insulating layer 32, and a printed wiring board 33. The first insulating layer 31, the second insulating layer 32, and the printed wiring board 33 are stacked in this order along the Z-axis negative direction (first direction).

A material of the first insulating layer 31 and a material of the second insulating layer 32 are, for example, a silicon oxide or a silicon nitride. The material of the first insulating layer 31 and the material of the second insulation 32 are not necessarily the same.

The printed wiring board 33 includes printed wiring (not illustrated). The printed wiring board 33 includes an area in which the printed wiring is provided (wiring area) and an area in which the printed wiring is not provided (insulating area).

The memory controller 13, the non-volatile memory 14, and the micro-strip line 40 are provided on the side of the surface (upper surface) of the printed wiring board 33 in the Z-axis negative direction.

The memory controller 13 and the non-volatile memory 14 are disposed in the wiring area of the printed wiring board 33. The memory controller 13 and the non-volatile memory 14 are electrically connected via the printed wiring. On the other hand, the micro-strip line 40 is disposed in the insulating area of the printed wiring board 33.

Note that the non-volatile memory 14 also can be disposed in the side of the surface (lower surface) of the printed wiring board 33 in the Z-axis positive direction. Also, instead of the micro-strip line, other wiring (transmission line) such as a stripline can be used.

The first pad electrode 41 is provided on the upper surface side of the printed wiring board 33. The first pad electrode 41 is connected to one end (end in the Y-axis negative direction) of the micro-strip line 40.

The second pad electrode 42 is provided on the surface (upper surface) of the memory controller 13 in the Z-axis negative direction. The first pad electrode 41 and the second pad electrode 42 are connected to by the bonding wire 43. As a result, the micro-strip line 40 and the memory controller 13 are electrically connected.

As illustrated in FIG. 6 and FIG. 8, another end (end in the Y-axis positive direction) of the micro-strip line 40 is connected to one end (end in the Z-axis negative direction) of the first via plug 51. The first via plug 51 is provided in the printed wiring board 33 and the second insulating layer 32. Another end (end in the Z-axis positive direction) of the first via plug 51 is connected to the connection terminal 11P. The first via plug 51 is formed, for example, by using electrically conductive paste or plating. In FIG. 6 and FIG. 8, the first via plug 51 formed by using electrically conductive paste is illustrated.

As illustrated in FIG. 8, on the upper surface side of the printed wiring board 33, the ESD protection element 12A, the footprint 60, and the first ground plane 71 are provided. The ESD protection element 12A is mounted on the footprint 60.

As illustrated in FIG. 5 and FIG. 8, the footprint 60 includes a first electrically conductive part 61 and a second electrically conductive part 62. The first terminal (the first terminal T1 illustrated in FIG. 2) and the second terminal (the second terminal T2 illustrated in FIG. 2) of the ESD protection element 12A are electrically connected to the first electrically conductive part 61 and the second electrically conductive part 62, respectively.

The first terminal of the ESD protection element 12A is connected to the one end (the end in the Z-axis negative direction) of the first via plug 51 via the first electrically conductive part 61. The second terminal of the ESD protection element 12A is connected to the first ground plane 71 via the second electrically conductive part 62. The first ground plane 71 has ground electric potential. Note that the footprint is also referred to as a pad, a pad electrode, or a land.

The first electrically conductive part 61, the second electrically conductive part 62, and the first ground plane 71 are obtained, for example, by etching one metal film. The metal film is, for example, a copper film.

As illustrated in FIG. 6, the second ground plane 72 is provided in the printed wiring board 33. The second ground plane 72 has the ground electric potential. The second ground plane 72 is physically separated from the first via plug 51. The second ground plane 72 is not electrically connected to the first via plug 51. In the Z-axis positive direction of (below) the micro-strip line 40, the second ground plane 72 has a solid shape.

The connection terminal 11P is provided in the first insulating layer 31. The first insulating layer 31 includes an opening 81 from which the connection terminal 11P is exposed.

Herein, when the exposed connection terminal 11P is electrically charged with static electricity, electro static discharge (ESD) may occur. The ESD is a cause which brings about a surge. When the surge enters the memory device 1 from the connection terminal 11P, there is a possibility that the memory controller 13 or the non-volatile memory 14 is destroyed.

However, when the ESD protection element 12A is used, the surge generated by the ESD flows to the first ground plane 71 via the ESD protection element 12A, so that the destruction (influence of the ESD) of the memory controller 13 or the non-volatile memory 14 caused by the ESD is suppressed.

Moreover, even when the frequencies of electric signals further increase in the future, the memory device 1 of the present embodiment exerts the effect that deterioration in the transmission characteristics of the electric signals can be suppressed. Hereinafter, this point will be further described.

In the present embodiment, the ESD protection element 12A is connected between the connection terminal 11P and the second pad electrode 42 via the footprint 60. In other words, the ESD protection element 12A is connected between the connection terminal 11P and the second pad electrode 42 without going through a branch wiring that is separated from a single wiring (hereinafter, referred to as first wiring).

The above described first wiring comprises the footprint 60 (the first electrically conductive part 61), the first via plug 51, the micro-strip line 40, the first pad electrode 41, and the bonding wire 43.

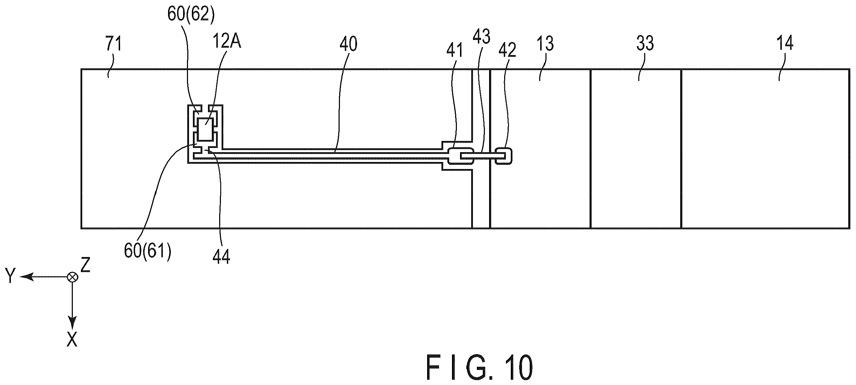

FIG. 10 is a plan view of a memory device according to a comparative example. In the memory device according to the comparative example, a first electrically conductive part 61 is connected to branch wiring 44 branched from a micro-strip line 40. Therefore, in the case of the comparative example, an ESD protection element 12A is connected between a connection terminal 11P (not illustrated) and a second pad electrode 42 via the branch wiring 44.

The branch wiring 44 generates parasitic inductance. Also, a PN junction of a diode constituting the ESD protection element 12A generates parasitic capacitance. The parasitic inductance and the parasitic capacitance constitute an LC serial resonance circuit. As a result, LC serial resonance circuits are connected in parallel to the above described first wiring.

Therefore, when an electric signal having a resonance frequency of the LC serial resonance circuit flows in the first wiring, deterioration in the transmission characteristics of the electric signal that the electric signal largely attenuates occurs. If the frequency of the electric signal further increases in the future, even if the length of the branch wiring is short, there is a possibility that the deterioration in the transmission characteristics of the electric signal (influence of the LC serial resonance circuit) will not be ignorable any more.

Since the memory device 1 of the present embodiment does not use the branch wiring, even when the frequencies of electric signals further increase in the future, the deterioration in the transmission characteristics of the electric signals can be suppressed.

As described above, according to the present embodiment, the memory device 1, which can suppress the influence of ESD by the ESD protection element 12A and can suppress the deterioration in the transmission characteristics of electric signals even when the frequencies of the electric signals are further increased in the future, can be provided.

### (Second Embodiment)

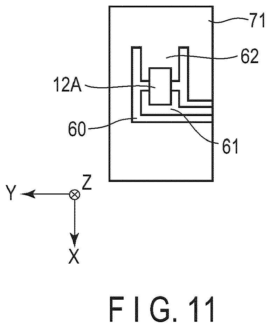

FIG. 11 is a plan view of a footprint of a memory device according to a second embodiment. FIG. 11 corresponds to FIG. 9 of the first embodiment.

The present embodiment is different from the first embodiment in a point that a shape of the second electrically conductive part 62 is a solid shape. Hereinafter, this point will be further described.

In the plane (X-Y plane) defined by the X-axis and the Y-axis, the size of the second electrically conductive part 62 in the Y-axis direction is constant regardless of the X-axis coordinate thereof. In other words, in the present embodiment, the shape of the second electrically conductive part 62 in the X-Y plane is an oblong having a side parallel to the X-axis and a side parallel to the Y-axis as two sides. Note that, in the first and second embodiments, a shape of the first electrically conductive part 61 is a solid shape. According to the present embodiment, the part which can serve as an induction component of an LC serial resonance circuit can be reduced also at the connection part of the second electrically conductive part 62 with a first ground plane 71. As a result, the deterioration in the transmission characteristics of electric signals can be more effectively suppressed.

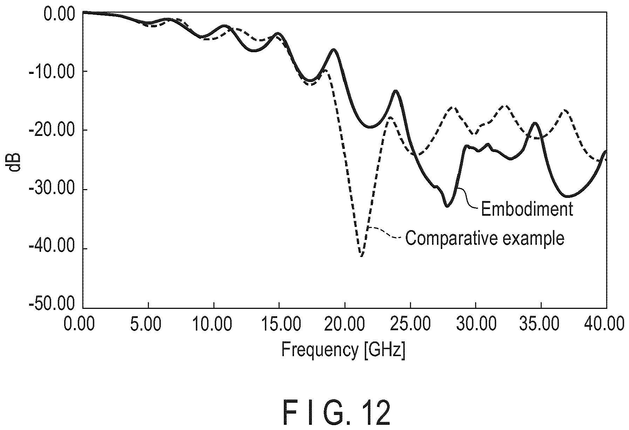

FIG. 12 is a characteristic chart illustrating transmission characteristics of the electric signals of the memory device according to the embodiment and transmission characteristics of the electric signals of a memory device according to a comparative example. A vertical axis illustrates intensities (signal intensities) of the electric signals, and a horizontal axis illustrates frequencies of the electric signals. In addition, the memory device according to the comparative example is the above described memory device illustrated in FIG. 10.

According to FIG. 12, the signal intensity is ensured at the frequencies in the vicinity of 0 to 24 GHz in the present embodiment, while the signal intensity is not ensured at the frequencies in the vicinity of 24 GHz in the comparative example. This means that the electric signal of the third harmonic of a basic frequency (8 GHz) of PCIExpress (PCle) (registered trademark) 4.0 (Gen 4) can be transmitted in the present embodiment.

When a bit string in which "0" data and "1" data alternately continues is transmitted, a high frequency of 24 GHz is generated. The frequency of 24 GHz is the maximum frequency expected in PCle 4.0. In actual data transmission, frequencies lower than 24 GHz are usually generated due to transmission bit patterns. In the case of the comparative example, since the signal intensity is lowered in the vicinity of 21 GHz, there is a possibility that the transmission of the electric signals having the frequencies in the vicinity of 21 GHz is disturbed.

### (Third Embodiment)

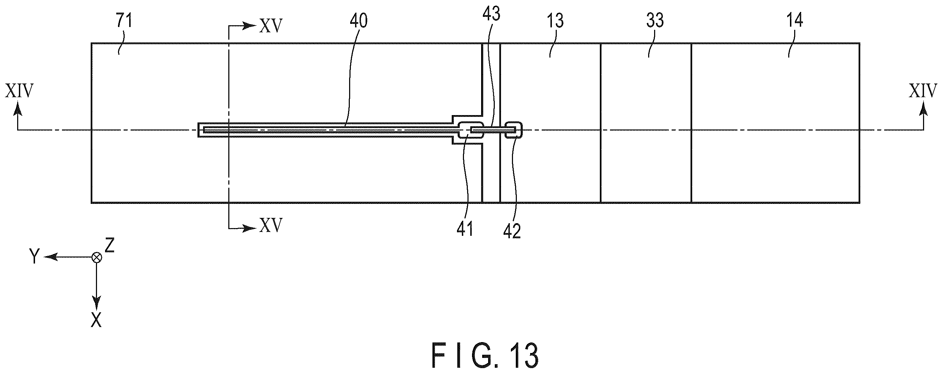

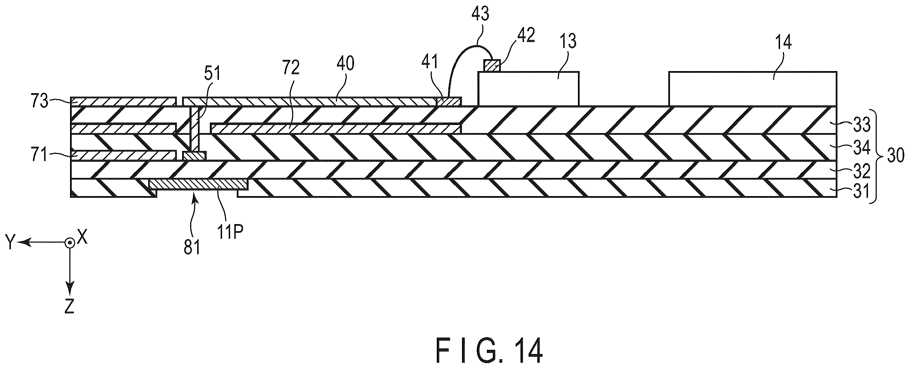

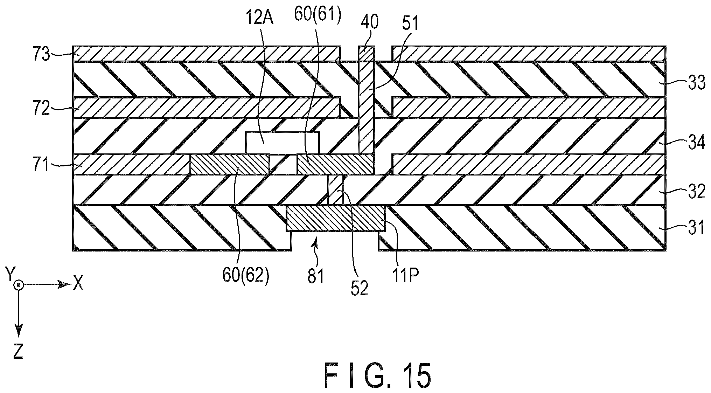

FIG. 13 is a plan view of a memory device according to a third embodiment. FIG. 14 is a cross-sectional view along a line XIV-XIV of FIG. 13. FIG. 15 is a cross-sectional view along a line XV-XV of FIG. 13.

In the first embodiment and the second embodiment, the ESD protection element is provided on the upper surface side of the printed wiring board of the substrate, however, in the present embodiment, an ESD protection element is provided in an insulating layer of a substrate.

As illustrated in FIG. 14, the substrate 30 of the present embodiment includes a first insulating layer 31, a second insulating layer 32, a third insulating layer 34, and a printed wiring board 33. The first insulating layer 31, the second insulating layer 32, the third insulating layer 34, and the printed wiring board 33 are stacked in this order along the Z-axis negative direction (first direction).

As illustrated in FIG. 15, the ESD protection element 12A is provided in the third insulating layer 34. In the third insulating layer 34, a first electrically conductive part 61, a second electrically conductive part 62, and a first ground plane 71 are further provided. The second terminal of the ESD protection element 12A is connected to the first ground plane 71 via the second electrically conductive part 62.

A first via plug 51 is provided in the printed wiring board 33 and the third insulating layer 34. Another end (end in the Z-axis positive direction) of the first via plug 51 is connected to the first electrically conductive part 61. A second via plug 52 is provided in the second insulating layer 32. One end (end in the Z-axis negative direction) of the second via plug 52 is connected to the first electrically conductive part 61. Another end (end in the Z-axis positive direction) of the second via plug 52 is connected to a connection terminal 11P.

The ESD protection element 12A is connected between the connection terminal 11P and a second pad electrode 42 without going through the branch wiring. Therefore, the memory device of the present embodiment can suppress the deterioration in the transmission characteristics of electric signals even when the frequencies of the electric signals further increase in the future.

Also, in the present embodiment, the ESD protection element 12A is provided in the third insulating layer 34 of the substrate 30. Mounting the ESD protection element 12A in the substrate 30 in this manner also leads to suppressing the deterioration in the transmission characteristics of electric signals.

Note that, in the memory device of the above described embodiment, the number of the layers including the printed wiring is one, but the number of the layers including the printed wiring may be two or more.

Part or all of generic concepts, medium concepts, and specific concepts of the above described embodiments and other embodiments, which are not described above, can be expressed, for example, by following Notes 1 to 18 and arbitrary combinations of Notes 1 to 18 (excluding apparently contradicting combinations).

### [NOTE 1]

A memory device comprising:
a substrate;
a non-volatile memory that is provided on the substrate;
a memory controller that is provided on the substrate and connected to the non-volatile memory;
a first wiring that is provided on the substrate and includes one end and another end, the one end being connected to the memory controller;
a footprint that is provided on the substrate and connected to the another end of the first wiring;
an ESD protection element that is provided on the substrate and connected to the footprint;
a connection terminal that is provided on the substrate and electrically connectable to a host device; and
a first via plug that is provided in the substrate, wherein one end is connected to the another end of the first wiring, another end is connected to the connection terminal.

### [NOTE 2]

The memory device according to note 1, comprising a first ground plane that is provided on the substrate and connected to the footprint.

### [NOTE 3]

The memory device according to note 2, wherein
the ESD protection element includes a first terminal and a second terminal,
the footprint includes a first electrically conductive part connected to the first terminal and a second electrically conductive part connected to the second terminal,
the one end of the first via plug is connected to the first electrically conductive part of the footprint.

### [NOTE 4]

The memory device according to note 3, wherein the first ground plane is connected to the second electrically conductive part of the footprint.

### [NOTE 5]

The memory device according to note 4, comprising a second ground plane that is provided in the substrate and disposed below the first wiring.

### [NOTE 6]

The memory device according to note 5, wherein a shape of the second ground plane is a solid shape.

### [NOTE 7]

The memory device according to note 6, wherein a shape of the second electrically conductive part is a solid shape.

### [NOTE 8]

The memory device according to note 6, wherein
the substrate includes an insulating layer and a printed wiring board that are stacked in a first direction,
the non-volatile memory, the memory controller, the first wiring, the footprint, the ESD protection element, and the first ground plane are provided on the printed wiring board,
the first via plug is provided in the printed wiring board and the insulating layer.

### [NOTE 9]

The memory device according to note 8, wherein
the insulating layer includes a first insulating layer and a second insulating layer,
the first insulating layer, the second insulating layer, and the printed wiring board are stacked in this order in the first direction,
the first via plug is provided in the printed wiring board and the second insulating layer.

### [NOTE 10]

A memory device comprising:
a substrate;
a non-volatile memory that is provided on the substrate;
a memory controller that is provided on the substrate and connected to the non-volatile memory;
a first wiring that is provided on the substrate and includes one end and another end, the one end being connected to the memory controller;
an ESD protection element that is provided in the substrate;
a footprint that is provided in the substrate and connected to the ESD protection element;
a first via plug that is provided in the substrate, wherein one end is connected to the another end of the first wiring, another end is connected to the footprint;
a connection terminal that is provided on the substrate and electrically connectable to a host device; and
a second via plug that is provided in the substrate, wherein one end is connected to the footprint, another end is connected to the connection terminal.

### [NOTE 11]

The memory device according to note 10, wherein
the ESD protection element includes a first terminal and a second terminal,
the footprint includes a first electrically conductive part connected to the first terminal and a second electrically conductive part connected to the second terminal,
the another end of the first via plug is connected to the first electrically conductive part of the footprint,
the one end of the second via plug is connected to the first electrically conductive part of the footprint.

### [NOTE 12]

The memory device according to note 11, comprising
a first ground plane and a second ground plane that are provided on the substrate, wherein
the first ground plane is connected to the second electrically conductive part of the footprint,
the second ground plane is disposed below the first wiring.

### [NOTE 13]

The memory device according to note 12, wherein
the substrate includes a first insulating layer, a second insulating layer, a third insulating layer, and a printed wiring board,
the first insulating layer, the second insulating layer, and the printed wiring board are stacked in this order in a first direction.

### [NOTE 14]

The memory device according to note 13, wherein
the non-volatile memory, the memory controller, and the first wiring are provided on the printed wiring board,
the second via plug is provided in the second insulating layer,
the footprint, the ESD protection element, and the first ground plane are provided in the third insulating layer,
the second ground plane is provided in the printed wiring board,
the first via plug is provided in the printed wiring board and the third insulating layer.

### [NOTE 15]

The memory device according to note 9 or 14, wherein
the connection terminal is provided on the first insulating layer,
the first insulating layer includes an opening exposing the connection terminal.

### [NOTE 16]

The memory device according to any of notes 1 to 15, wherein the first wiring is a micro-strip line.

### [NOTE 17]

The memory device according to any of notes 1 to 16, wherein
the ESD protection element includes a first diode and a second diode,
a cathode of the first diode and a cathode of the second diode are connected.

### [NOTE 18]

The memory device according to note 17, wherein each of the first diode and the second diode is a Zener diode.

While certain embodiments have been described, these embodiments have been presented by way of example only, and are not intended to limit the scope of the inventions. The novel embodiments may be embodied in a variety of other forms, various omissions, substitutions and changes may be made without departing from the spirit of the inventions. These embodiments and their modifications are included in the substance of the invention, and are included in the scope of the invention described in the claims and equivalents thereof.

### Reference Signs List

- T1: First terminal
- T2: Second terminal
- 1: Memory device
- 10: Card case
- 11: Terminal group
- 11P: Connection terminal
- 12: ESD protection circuit
- 12A: ESD protection element
- 12A1: First diode
- 12A2: Second diode
- 14: Non-volatile memory
- 13: Memory controller
- 20: Chamfered part
- 21: First surface
- 22: Second surface
- 30: Substrate
- 31: First insulating layer
- 32: Second insulating layer
- 33: Printed wiring board
- 34: Third insulating layer
- 40: Micro-strip line
- 41: First pad electrode
- 42: Second pad electrode
- 43: Bonding wire
- 44: Branch wiring
- 51: First via plug
- 52: Second via plug
- 60: Footprint
- 61: First electrically conductive part
- 62: Second electrically conductive part
- 71: First ground plane
- 72: Second ground plane
- 73: Third ground plane
- 81: Opening

## Claims

1. A memory device comprising:
substrate;
a non-volatile memory that is provided on the substrate;
a memory controller that is provided on the substrate and connected to the non-volatile memory;
a first wiring that is provided on the substrate and includes one end and another end, wherein the one end is connected to the memory controller;
a footprint that is provided on the substrate and connected to the another end of the first wiring;
an ESD protection element that is provided on the substrate and connected to the footprint;
a connection terminal that is provided on the substrate and electrically connectable to a host device;
a first via plug that is provided in the substrate, wherein one end is connected to the another end of the first wiring, another end is connected to the connection terminal.

2. The memory device according to claim 1, comprising a first ground plane that is provided on the substrate and connected to the footprint.

3. The memory device according to claim 2,
wherein:
the ESD protection element includes a first terminal and a second terminal;
the footprint includes a first electrically conductive part connected to the first terminal and a second electrically conductive part connected to the second terminal; and
the one end of the first via plug is connected to the first electrically conductive part of the footprint.

4. The memory device according to claim 3, wherein the first ground plane is connected to the second electrically conductive part of the footprint.

5. The memory device according to claim 4, comprising a second ground plane that is provided in the substrate and disposed below the first wiring.

6. The memory device according to claim 5, wherein a shape of the second ground plane is a solid shape.

7. The memory device according to claim 6, wherein a shape of the second electrically conductive part is a solid shape.

8. The memory device according to claim 6,
wherein:
the substrate includes an insulating layer and a printed wiring board that are stacked in a first direction;
the non-volatile memory, the memory controller, the first wiring, the footprint, the ESD protection element and the first ground plane are provided on the printed wiring board; and
the first via plug is provided in the printed wiring board and the insulating layer.

9. The memory device according to claim 8,
wherein:
the insulating layer includes a first insulating layer and a second insulating layer;
first insulating layer, second insulating layer, and the printed wiring board are stacked in this order in the first direction; and
the first via plug is provided in the printed wiring board and the second insulating layer.

10. A memory device comprising:
a substrate;
a non-volatile memory that is provided on the substrate;
a memory controller that is provided on the substrate and connected to the non-volatile memory;
a first wiring that is provided on the substrate and includes one end and another end, wherein the one end is connected to the memory controller;
an ESD protection element that is provided in the substrate;
a footprint that is provided in the substrate and connected to the ESD protection element;
a first via plug that is provided in the substrate, wherein one end is connected to the another end of the first wiring, another end is connected to the footprint;
a connection terminal that is provided on the substrate and electrically connectable to a host device;
a second via plug that is provided in the substrate, wherein one end is connected to the footprint, another end is connected to the connection terminal.

11. The memory device according to claim 10,
wherein:
the ESD protection element includes a first terminal and a second terminal;
the footprint includes a first electrically conductive part connected to the first terminal and a second electrically conductive part connected to the second terminal;
the another end of the first via plug is connected to the first electrically conductive part of the footprint; and
the one end of the second via plug is connected to the first electrically conductive part of the footprint.

12. The memory device according to claim 11, comprising a first ground plane and a second ground plane that are provided on the substrate,
wherein:
the first ground plane is connected to the second electrically conductive part of the footprint; and
the second ground plane is disposed below the first wiring.

13. The memory device according to claim 12,
wherein:
the substrate includes a first insulating layer, a second insulating layer, a third insulating layer and a printed wiring board; and
the first insulating layer, the second insulating layer and the printed wiring board are stacked in this order in a first direction.

14. The memory device according to claim 13,
wherein:
the non-volatile memory, the memory controller, and the first wiring are provided on the printed wiring board;
the second via plug is provided in the second insulating layer;
the footprint, the ESD protection element and the first ground plane are provided in the third insulating layer;
the second ground plane is provided in the printed wiring board; and
the first via plug is provided in the printed wiring board and the third insulating layer.

15. The memory device according to claim 9 or 14,
wherein:
the connection terminal is provided on the first insulating layer; and
the first insulating layer includes an opening exposing the connection terminal.

16. The memory device according to any of claims 1 to 15, wherein the first wiring is a micro-strip line.

17. The memory device according to any of claims 1 to 16,
wherein:
the ESD protection element includes a first diode and a second diode; and
a cathode of the first diode and a cathode of the second diode are connected.

18. The memory device according to claim 17,
wherein each of the first diode and the second diode is a Zener diode.

## Amended claims

### Amended claims under Art. 19.1 PCT

1. (Amended) A memory device comprising:
a substrate that includes a first surface and a second surface opposite to the first surface;
a non-volatile memory that is provided on the first surface of the substrate;
a memory controller that is provided on the first surface of the substrate and connected to the non-volatile memory;
a first interconnect that is provided on the first surface of the substrate and includes one end and another end;
a first pad electrode that is provided on the first surface of the substrate;
a second pad electrode that is provided on the memory controller;
a wire that includes one end and another end and connects the first pad electrode and the second pad electrode;
a footprint that is provided on the first surface of the substrate and includes a first electrically conductive part and a second electrically conductive part;
a first ground plane that is provided on the first surface of the substrate and connected to the footprint;
a second ground plane that is provided in the substrate;
an ESD protection element that is connected to the footprint and includes a first terminal and a second terminal;
a connection terminal that is exposed from the second surface of the substrate and electrically connectable to a host device; and
a first via plug that is provided in the substrate and includes one end and another end,
wherein:
a shape of the second electrically conductive part is a solid shape;
a shape of the second ground plane is a solid shape;
the one end of the wire is connected to the first pad electrode;
the another end of the wire is connected to the second pad electrode;
the one end of the first interconnect is connected to the first pad electrode;
the another end of the first interconnect is connected to the first electrically conductive part of the footprint;
the one end of the first via plug is connected to the first electrically conductive part of the footprint;
the first terminal of the ESD protection element is connected to the first electrically conductive part of the footprint; and
the another end of the first via plug is connected to the connection terminal.

2. (Deleted)

3. (Amended) The memory device according to claim 1, wherein the second electrically conductive part of the footprint is connected to the second terminal of the ESD protection element.

4. The memory device according to claim 3, wherein the first ground plane is connected to the second electrically conductive part of the footprint.

5. (Deleted)

6. (Deleted)

7. (Deleted)

8. (Amended) The memory device according to claim 4, wherein:
the substrate includes an insulating layer and a printed wiring board;
the insulating layer and the printed wiring board are stacked in this order in a first direction that is from the second surface toward the first surface;
the non-volatile memory, the memory controller, the first interconnect, the footprint and the first ground plane are provided on the printed wiring board;
the ESD protection element is provided on the footprint; and
the first via plug is provided in the printed wiring board and in the insulating layer.

9. The memory device according to claim 8, wherein:
the insulating layer includes a first insulating layer and a second insulating layer;
first insulating layer, second insulating layer and the printed wiring board are stacked in this order in the first direction; and
the first via plug is provided in the printed wiring board and in the second insulating layer.

10. (Amended) A memory device comprising:
a substrate that includes a first surface and a second surface opposite to the first surface;
a non-volatile memory that is provided on the first surface of the substrate;
a memory controller that is provided on the first surface of the substrate and connected to the non-volatile memory;
a first interconnect that is provided on the first surface of the substrate and includes one end and another end;
a first pad electrode that is provided on the first surface of the substrate;
a second pad electrode that is provided on the memory controller;
a wire that includes one end and another end and connects the first pad electrode and the second pad electrode;
an ESD protection element that is provided in the substrate and includes a first terminal and a second terminal;
a footprint that is provided in the substrate and includes a first electrically conductive part and a second electrically conductive part;
a first via plug that is provided in the substrate and includes one end and another end;
a connection terminal that is exposed from the second surface of the substrate and electrically connectable to a host device; and
a second via plug that is provided in the substrate and includes one end and another end,
wherein:
the one end of the wire is connected to the first pad electrode;
the another end of the wire is connected to the second pad electrode;
the one end of the first interconnect is connected to the first pad electrode;
the another end of the first interconnect is connected to the one end of the first via plug;
the another end of the first via plug is connected to the first electrically conductive part of the footprint;
the first terminal of the ESD protection element is connected to the first electrically conductive part of the footprint; and
the another end of the second via plug is connected to the connection terminal.

11. (Amended) The memory device according to claim 10, wherein the second electrically conductive part of the footprint is connected to the second terminal of the ESD protection element.

12. (Amended) The memory device according to claim 11, comprising a first ground plane that is provided on the first surface of the substrate and a second ground plane that is provided in the substrate,
wherein the first ground plane is connected to the second electrically conductive part of the footprint.

13. (Amended) The memory device according to claim 12,
wherein:
the substrate includes a first insulating layer, a second insulating layer, a third insulating layer and a printed wiring board; and
the first insulating layer, the second insulating layer and the printed wiring board are stacked in this order in a first direction that is from the second surface toward the first surface.

14. (Amended) The memory device according to claim 13,
wherein:
the non-volatile memory, the memory controller and the first interconnect are provided on the printed wiring board;
the second via plug is provided in the second insulating layer;
the footprint, the ESD protection element and the first ground plane are provided in the third insulating layer;
the second ground plane is provided in the printed wiring board; and
the first via plug is provided in the printed wiring board and in the third insulating layer.

15. (Amended) The memory device according to claim 9 or 14,
wherein:
the connection terminal is provided on the first insulating layer; and
the first insulating layer includes an opening from which the connection terminal is exposed.

16. (Amended) The memory device according to claim 1, 3 or 4, or any of claims 8 to 15, wherein the first interconnect is a micro-strip line.

17. (Amended) The memory device according to claim 1, 3 or 4, or any of claims 8 to 16,
wherein:
the ESD protection element includes a first diode and a second diode; and
a cathode of the first diode and a cathode of the second diode are connected.

18. The memory device according to claim 17,
wherein each of the first diode and the second diode is a Zener diode.

19. (Added) The memory device according to claim 1, wherein the second pad electrode is connected to the connection terminal via the wire, the first pad electrode, the first interconnect, the footprint and the first via plug.

20. (Added) The memory device according to claim 1, wherein, when viewing the ESD protection element and the footprint from above the first surface of the substrate, an area in which the ESD protection element is provided and an area in which the footprint is provided are partially overlapped.

21. (Added) The memory device according to claim 10, wherein the second pad electrode is connected to the connection terminal via the wire, the first pad electrode, the first interconnect, the first via plug, the footprint and the second via plug.

22. (Added) A memory device comprising:
a substrate;
a non-volatile memory that is provided on the first surface of the substrate;
a memory controller that is provided on the first surface of the substrate and connected to the non-volatile memory;
a first interconnect that is provided on the first surface of the substrate and includes one end and another end, wherein the one end is connected to the memory controller;
a footprint that is provided on the first surface of the substrate, connected to the another end of the first interconnect, includes a first electrically conductive part and a second electrically conductive part;
a first ground plane that is provided on the first surface of the substrate and connected to the footprint;
a second ground plane that is provided in the substrate;
an ESD protection element that is connected to the footprint, connected to the footprint, and includes a first terminal and a second terminal;
a connection terminal that is exposed from the second surface of the substrate and electrically connectable to a host device; and
a first via plug that is provided in the substrate, wherein one end is connected to the another end of the first interconnect, another end is connected to the connection terminal,
wherein:
a shape of the first electrically conductive part is a solid shape; and
a shape of the second electrically conductive part is a solid shape.

23. (Added) The memory device according to claim 22,
wherein:
the first electrically conductive part of the footprint is connected to the first terminal of the ESD protection element;
the second electrically conductive part of the footprint is connected to the second terminal of the ESD protection element; and
the one end of the first via plug is connected to the first electrically conductive part of the footprint.

24. (Added) The memory device according to claim 23, wherein the first ground plane is connected to the second electrically conductive part of the footprint.

25. (Added) The memory device according to claim 24, wherein a shape of the second ground plane is a solid shape.

26. (Added) The memory device according to claim 25,
wherein:
the substrate includes an insulating layer and a printed wiring board;
the insulating layer and the printed wiring board are stacked in this order in a first direction that is from the second surface toward the first surface;
the non-volatile memory, the memory controller, the first interconnect, the footprint, and the first ground plane are provided on the printed wiring board;
the ESD protection element is provided on the footprint; and
the first via plug is provided in the printed wiring board and in the insulating layer.

27. (Added) The memory device according to claim 26,
wherein:
the insulating layer includes a first insulating layer and a second insulating layer;
first insulating layer, second insulating layer and the printed wiring board are stacked in this order in the first direction; and
the first via plug is provided in the printed wiring board and in the second insulating layer.
